# EUROPEAN PATENT SPECIFICATION

(11) **EP 3 273 330 B1**
(45) Date of publication and mention of the grant of the patent: **20.10.2021**
(21) Application number: 17185087.8
(22) Date of filing: 03.07.2013
(51) Int. Cl.: G06F 3/044, H03K 17/96, G06F 3/041

(54) **PRESSURE SENSING DISPLAY DEVICE**
DRUCKMESSUNGSANZEIGEVORRICHTUNG
DISPOSITIF D'AFFICHAGE AVEC DÉTECTION DE PRESSION

(30) Priority: 05.07.2012 US 201261668439 P
(43) Date of publication of application: 24.01.2018
(62) Divisional of application: 13813515.7
(73) Proprietor: Cambridge Touch Technologies, Ltd., Cambridge CB4 0GN (GB)
(72) Inventor: Church, Corbin, Cambridge, Cambridgeshire CB3 0DL (GB); Nathan, Arokia, Cambridge, Cambridgeshire CB3 0DL (GB); Lai, Jackson Chi Sun, Mississauga, Ontario L5W 1W4 (CA); Cha, Suk-Bae, Tokyo, 106-0047 (JP)
(74) Representative: Dunleavy, Christopher Squire

(56) References cited:
- WO-A1-2011/156447
- US-A1- 2008 018 608
- US-A1- 2009 309 616

## Description

### Field

The described embodiments relate to touch sensing digital displays and, in particular, to force or pressure sensing in touch sensing displays.

### Background

Touch panel displays are widely used in consumer electronics, such as smartphones and computing tablets, among other devices. Broadly speaking, there are two types of touch panel technologies currently used in consumer electronics: projected capacitance and resistive. Both types of touch panels typically can only sense the location and time of a touch event on the touch panel (e.g., from a finger or stylus). The location of a touch event is typically recorded only in two dimensions (e.g., x-y coordinates). Conventional touch panels are unable to sense in a third dimension to determine the magnitude of a touch force (e.g., a z-coordinate). Prior attempts at three-dimensional sensing have typically focused on the inclusion of a sensitive analog element. Conventionally, the inclusion of an analog element in what is otherwise a digital system has been costly, bulky and non-trivial.

WO 2011/156447 A1 describes a touch screen display sensor that includes a transparent touch-sensing element disposed upon the surface of a transparent substrate and a force-sensing element disposed within the transparent touch-sensing element. The force-sensing element includes two sets of bands of micromesh and can include a pressure-responsive material between the bands of micromesh. The bands of micromesh include traces of a metallic conductor. The sets of bands of micromesh are spaced apart and occupy substantially parallel planes.

US 2009/309616 A1 describes a device including a first layer, a second layer, a third layer, a capacitive sensing component coupled to the first layer, and a force sensing component coupled to the first layer and the third layer and configured to detect the amount of force applied to the second layer. A method may include monitoring capacitance and voltage at one or more input sensors configured to detect changes in capacitance and to detect changes in applied force, detecting a change in capacitance, activating a capacitance response in response to detecting a change in capacitance, detecting a change in voltage, and activating a force response in response to detecting a change in voltage.

US 2008/018608 A1 discloses a data input device with a film-based pressure sensor including a first carrier film, a second carrier film and a spacer. The spacer has an opening delimiting an active zone, in which first and second electrodes are arranged such that, in response to a compressive force, an electrical contact is established. A control circuit able to operate in at least a first and a second mode is configured to measure, in the first mode a quantity indicative of electrical resistance and, in the second mode, a quantity indicative of a capacitance.

### Summary

In a first aspect, there is provided a projected capacitance touchscreen device comprising a pressure sensing assembly, the pressure sensing assembly comprising: a biasing electrode layer; a sensing electrode layer comprising a plurality of conductive traces, wherein each trace comprises one or more sensing pads; and a piezoelectric layer provided between the biasing electrode layer and the sensing electrode layer, wherein the pressure sensing layer acts as a dielectric. The pressure sensing assembly also includes a detection circuit operatively connected to the plurality of conductive traces of the sensing electrode layer and comprising a pressure sensing circuit and a capacitive sensing circuit, wherein the detection circuit is switchable between a first mode and a second mode such that only one of the pressure sensing circuit and the capacitive sensing circuit is operatively coupled to a conductive trace at any one time. In the first mode, the capacitive sensing circuit is configured to detect a change in capacitance at the conductive trace. In the second mode, the pressure sensing circuit is configured to detect a voltage induced across the piezoelectric layer, between the biasing electrode layer and the conductive trace. The detection circuit is configured to determine the location of an applied force based on the detected changes in capacitance and the magnitude of an applied force based on the detected changes in induced voltages

Further aspects of the invention are outlined in the dependent claims.

### Brief Description of the Drawings

A preferred embodiment of the present invention will now be described in detail with reference to the drawings, in which:
FIG. 1A is a simplified plan view of a display subassembly;
FIG. 1B is a simplified plan view of an example cover assembly;
FIG. 2 is a simplified cross-sectional view of a portion of an example display assembly;
FIG. 3 is a simplified cross-sectional view of another example display assembly;
FIG. 4 is a plan view of an example pad layout for the display assembly of
FIG. 3;

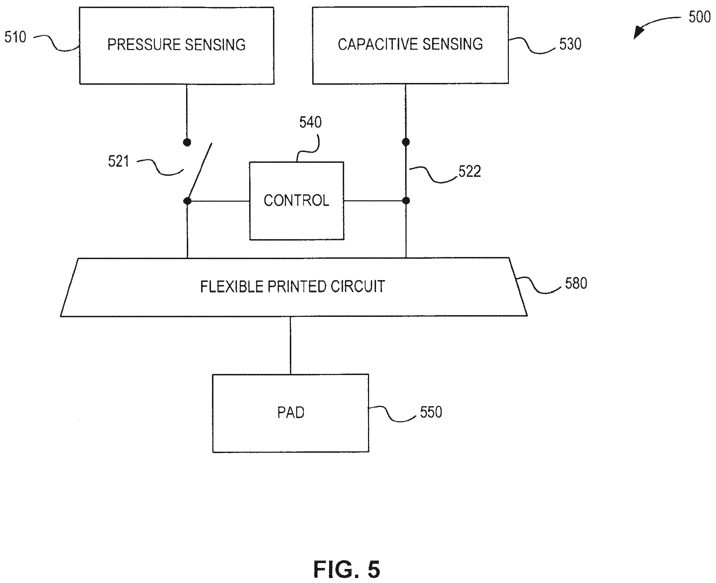

FIG. 5 is a simplified schematic diagram of an example sensor for combined projected capacitive and pressure sensing;

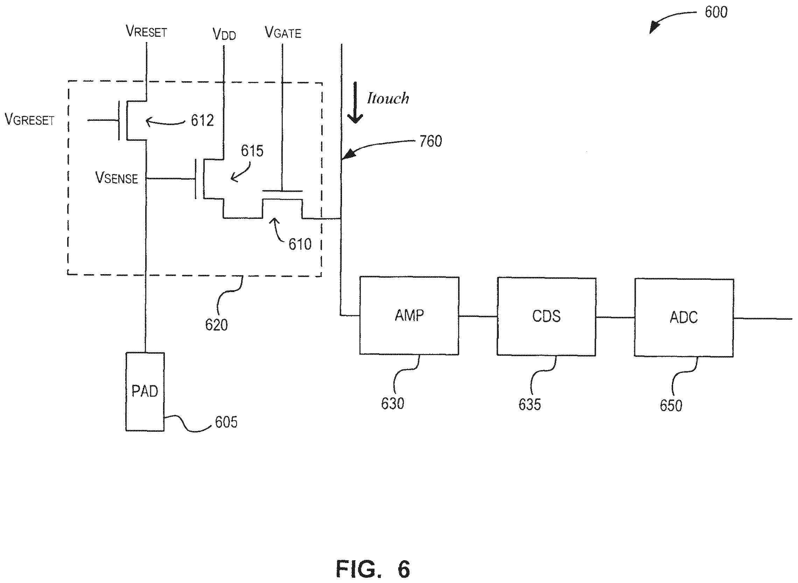

FIG. 6 is a schematic diagram of an example pressure sensing circuit;

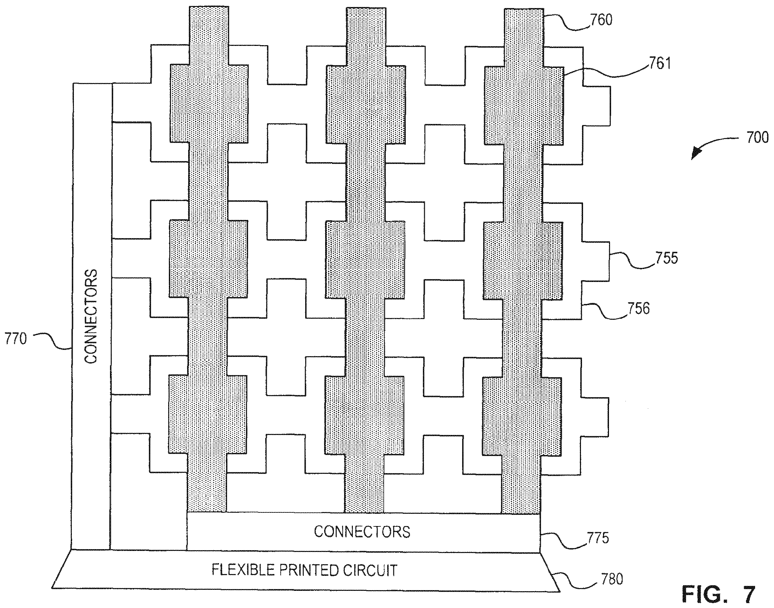

FIG. 7 is a cover assembly with an example pad and trace geometry;

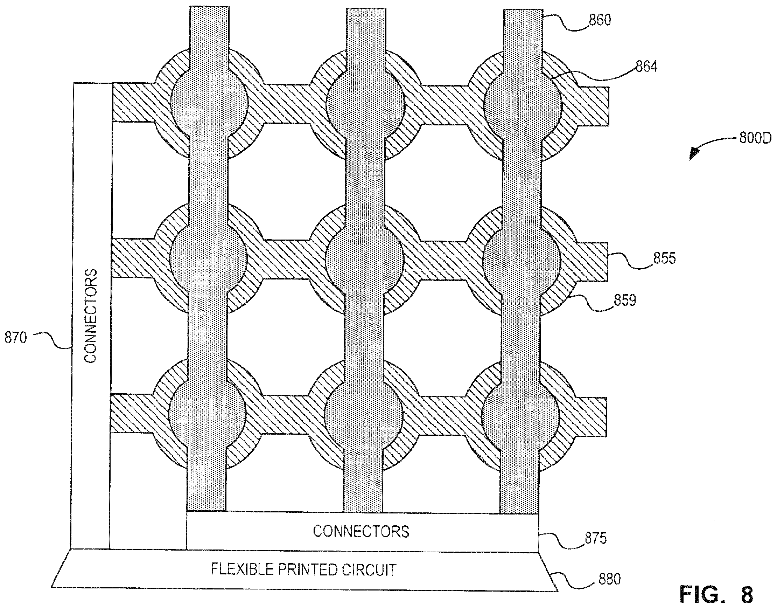

FIG. 8 is a cover assembly with another example pad and trace geometry; and

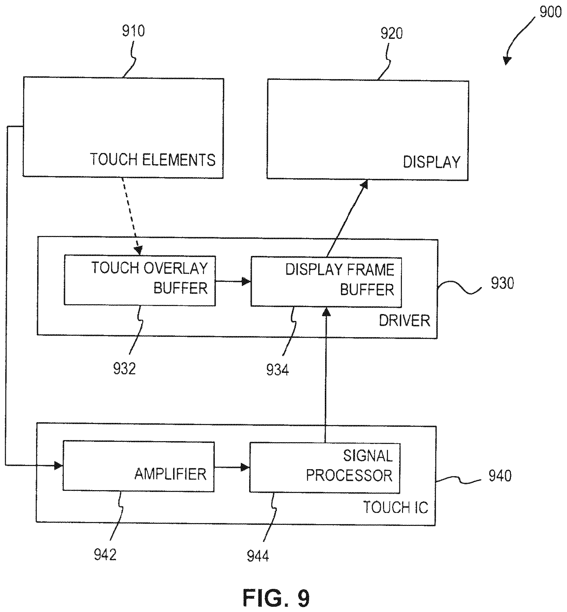

FIG. 9 is a simplified schematic of an example touch event signal flow.

### Description of Exemplary Embodiments

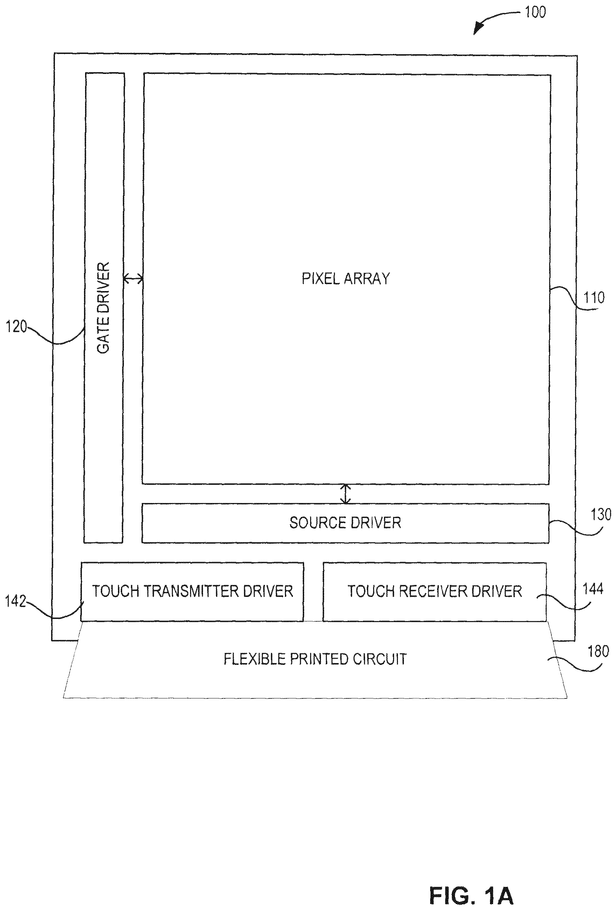

Referring now to FIG. 1A, there is illustrated a simplified plan view of a display subassembly such as that used in a touch sensitive display. Display subassembly 100 includes a pixel array 110, a gate driver 120 and a source driver 130.

Pixel array 10 may include a backplane with an active matrix comprising individually addressable pixels (e.g., liquid crystal display (LCD) or light emitting diode (LED) elements), and a frontplane for optical modulation (e.g., color filters, polarizers, etc.). The backplane may include a plurality of layers, formed of various materials such as glass, polyester and paper.

Each addressable pixel may comprise one or more transistors and, in particular, a thin-film transistor (TFT), for controlling the operation of the pixel. In some embodiments, each pixel may consist of separate sub-pixels, each individually controllable, that are provided with different color filters.

Gate driver 120 and source driver 130 are generally integrated circuits that drive the operation of pixel array 110. Both gate driver 120 and source driver 130 may be integrated into pixel array 110, or provided as separate circuits in a display module using, for example, a flexible printed circuit, chip on glass or chip on flex approach.

In operation, display subassembly 100 forms an image by scanning lines of pixels in pixel array 110. Gate driver 120 provides a signal to open or activate selected pixels (or sub-pixels) in each line of pixel array 110. Source driver 130 then charges each pixel in the line to a preconfigured voltage.

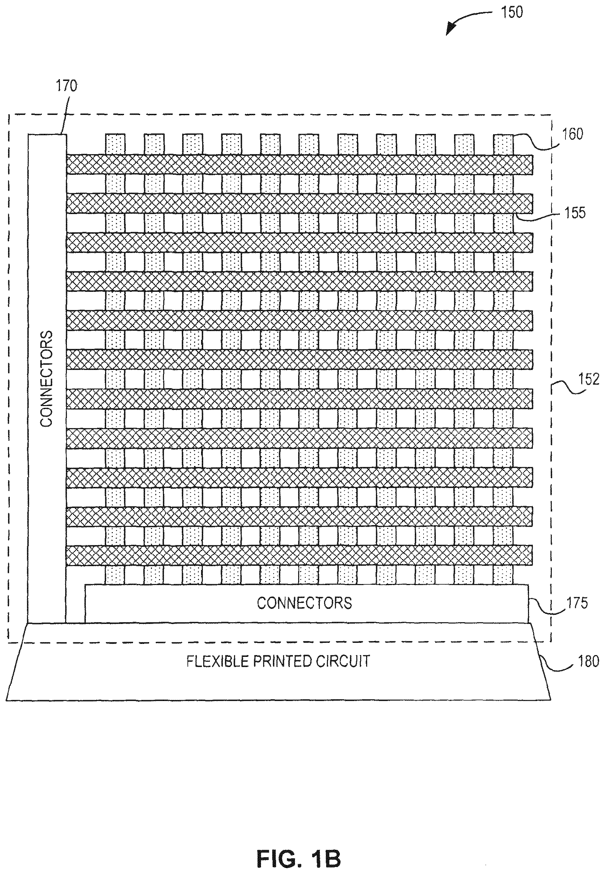

Referring now to FIG. 1B, there is illustrated a simplified plan view of an example cover assembly with integrated touch traces, such as that used in a touch sensitive display.

Cover assembly 150 generally includes multiple layers and may be fabricated by lamination or equivalent methods. In some embodiments, an air gap between layers may be acceptable. An outer layer 152 can be glass or plastic, and is generally the layer that a user may contact with a finger or stylus. A first layer of transmitter touch traces, such as horizontal traces 155, may be provided on the underside of the outer layer. The traces may be formed by depositing a suitable conductor on the glass substrate. For example, indium tin oxide (ITO) or indium zinc oxide (IZO) may be used, as they are substantially optically transparent and can be overlaid on a display pixel array, such as array 110 of FIG. 1A.

An intermediate dielectric or insulating layer (e.g., glass) can be provided, and a second layer of receiver touch traces, such as vertical traces 160, can be provided in similar fashion to form a projected capacitance (pro-cap)sensing grid.

In the illustrated example, each of the horizontal traces 155 is electrically coupled via a plurality of conductors 170 and a flexible printed circuit 180 to a transmitter driver circuit, such as transmitter driver 142 of FIG. 1A, located off-assembly. Similarly, each of the vertical traces 160 is electrically coupled via conductors 175 and flexible printed circuit 180 to a receiver driver circuit, such as receiver driver 144 of FIG. 1A. So as not to obscure the illustration, each of the respective conductive paths is not individually illustrated, however each horizontal and vertical trace may be individually and uniquely coupled to a respective input or output of the respective driver circuit.

Conductors 170 and 175 may be formed of ITO or IZO, or may be formed of opaque materials that exhibit lower resistance, thus allowing for more compact arrangement (e.g., at the periphery of a display).

In operation, transmitter driver 142 applies a voltage to the transmitter traces 160 to create an electrostatic field. In the absence of an external stimulus (e.g., finger or stylus), the electrostatic field has a regular pattern across the grid. Each intersection of a transmitter and receiver trace forms a capacitor, which has a corresponding capacitance that can be measured by a receiver circuit.

When a conductive object contacts the panel, the electrostatic field becomes locally distorted. This distortion causes a change in capacitance (e.g., reduction in mutual capacitance) at an intersection of the transmitter and receiver traces. This change in capacitance can be determined by measuring a voltage on each of the receiver traces 155, to identify the location of a touch event on the grid.

For a typical screen of between 4 and 5 diagonal inches, there are between 10 to 16 transmitter traces 160, and 10 to 16 receiver traces 155, resulting in between 100 to 256 distinct touch locations. Traces are typically between 4 to 6 mm in width, to capture a typical finger touch.

In the illustrated example, the image and touch driver circuits are shown as being integrated on the display panel, however in other embodiments, one or more driver circuits may be provided on a separate assembly, and connected via a flexible printed circuit or other suitable connector.

Provision of touch traces 155 and 160 in the cover assembly facilitates larger signal swings, which increase signal-to-noise ratio, due to the proximity of the finger or stylus to the traces.

In addition, by providing only touch traces on the cover assembly, the ease of repair or replacement is increased, while minimizing cost of repair, since the driving circuits are located on another module.

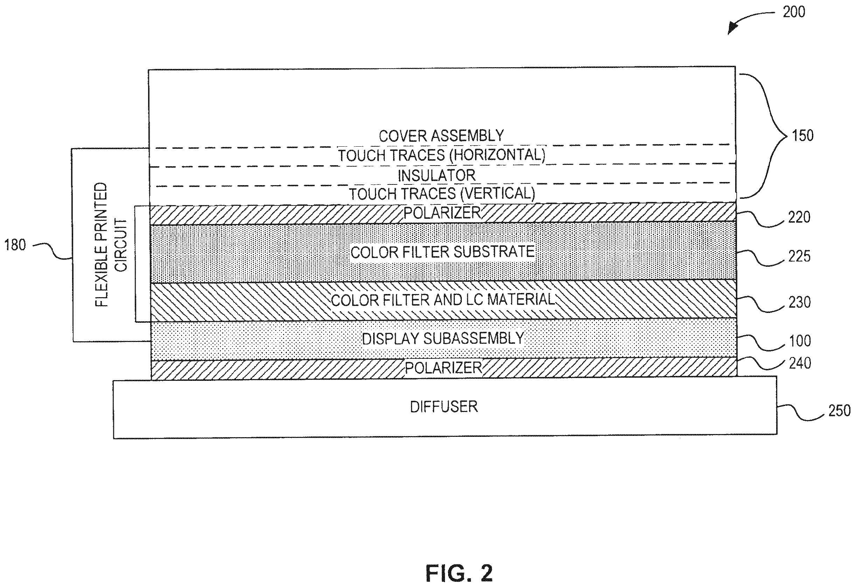

Referring now to FIG. 2, there is illustrated a simplified cross-sectional view of a portion of an example display assembly 200. Display assembly includes a display subassembly 100 of FIG. 1A and a cover assembly 150 of FIG. 1B, along with a flexible printed circuit 180 connecting touch traces to respective driver circuits.

In particular, display assembly 200 has a diffuser 250 that serves as a base layer (e.g., bottom layer or substrate). Diffuser 250 may be a light guide plate (LGP), a brightness enhancing film (BEF) or other suitable diffusing element that serves to diffuse light from, for example, an LED backlight that produces broad spectrum (e.g., white) light.

A polarizer 240 is stacked atop diffuser 250 to polarize light from diffuser 250 and direct it through display subassembly 100. Display subassembly 100 is a TFT layer that includes integrated circuits for controlling each pixel or sub-pixel element in the display assembly 200.

A color filter and liquid crystal layer 230 is stacked atop display subassembly 100. Layer 230 includes liquid crystal elements that respond to control outputs from display subassembly 100 to become selectively opaque or partially opaque. Color filter elements are used to admit only selected wavelengths to cause the pixels or sub-pixels to appear to provide only light of the desired color (e.g., red, green, blue).

A color filter substrate layer 225 is stacked atop layer 230. Color filter substrate layer 225 may be a glass substrate, for example, upon which the color filter portion of layer 230 is adhered or affixed. Generally, the liquid crystal portion of layer 230 is below the color filter portion. A further polarizer 220 may be provided to ensure that stray light does not escape.

A cover assembly 150 as described herein may be stacked atop the polarizer 220. As described, the horizontal and vertical touch traces of the cover assembly 150 may be coupled to respective driver circuits in the display subassembly 100.

Each of the layers of display assembly 200 may be fixed to the other, for example by lamination using a resin or other optically clear adhesive (OCA), portions of the assembly may also be sealed together during fabrication.

Current conventional touch screen displays generally employ pro-cap technology such as that described in FIGS. 1A, 1B and 2. However, currently there is no practical pro-cap technology that incorporates pressure sensing capability. In addition, current methods of pro-cap device construction and driving result in noisy signals that may result in degraded touch performance.

The described embodiments generally provide integrated touch displays with combined pressure and projected capacitance touch capabilities, and methods of fabricating the same. The described embodiments are generally built in a hybrid construction that results in low noise, low latency, low power and low cost. At least some embodiments provide a "one glass solution" (OGS) or "on-cell" construction, on a variety of substrate types (e.g., glass, film, or laminates thereof).

In general, the described embodiments combine all the conventional attributes of pro-cap technology with the additional capability of sensing force or pressure applied to a planar surface, where both the magnitude and location of the force are measured. In addition, the described embodiments may facilitate increased signal-to-noise ratio in the detection of pro-cap touch events and force, while also allowing for reduced latency effects.

The described embodiments are suitable for use in touch panels, including high resolution touch panels such as those found in mobile computing devices (e.g., smartphones, tablets), personal computers, industrial devices and the like.

Pressure sensing can be implemented in capacitive touch sensing devices by incorporating a layer of pressure sensing material in the display stack. This pressure sensing material is a material that exhibits a piezoelectric effect. That is, the pressure sensing material exhibits a change in one or more electrical property (e.g., voltage) corresponding to an applied force or pressure that deforms the material. An applied force induces a voltage across a piezoelectric material, which results in a current flowing between two terminals connected to the material.

In the case of piezoelectric materials, this change in electrical property is measured across a portion of the material using two leads or terminals.

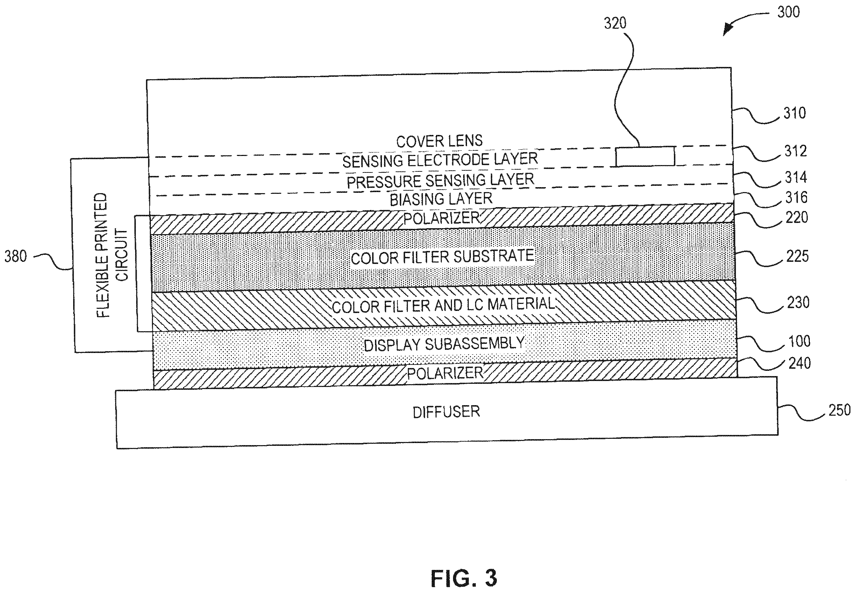

Referring now to FIG. 3, there is illustrated a simplified cross-sectional view of a portion of an example display assembly 300, which incorporates a pressure sensing layer. Display assembly 300 contains layers generally analogous to those of display assembly 200 of FIG. 2, which are labeled with like reference numerals.

In contrast to display assembly 200, display assembly 300 comprises a cover lens 310, a sensing electrode layer 312, a pressure sensing layer 314 and a biasing layer 316. Flexible printed circuit 380 is operatively connected to each of layers 312, 314 and 316, as well as display subassembly 100.

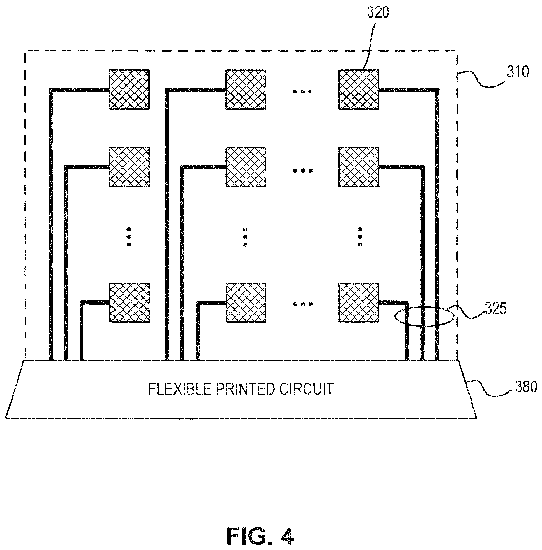

Sensing electrode layer 312 has a plurality of discrete pads 320 deposited, patterned, printed or laminated on cover lens 310. Only one sensing pad 320 is illustrated in FIG. 3, so as not to obscure the illustration. Each of the discrete pads may be formed of ITO, IZO or another suitable optically transparent conductor. Further detail regarding the layout of layer 312 is provided with reference to FIG. 4.

Pressure sensing layer 314 is formed of a pressure sensing material, being a piezoelectric material. The pressure sensing material also acts as a dielectric layer between sensing electrode layer 312 and biasing layer 316.

In some embodiments, biasing layer 316 may act as a single large driving electrode, which works in conjunction with each of the pads 320 in sensing electrode layer 312 to bias the pressure sensing material to facilitate pressure or force detection. Accordingly, when a force or pressure is applied to a portion of the assembly, one or more pads 320 in the vicinity of the applied force will register a change in voltage or current that will not be registered by the other pads 320 outside the vicinity of the applied force.

Biasing layer 316 may be formed of an optically transparent conductor such as ITO or IZO. In some embodiments, the biasing layer 316 may be a substantially uniform "blanket" layer (i.e., not patterned).

In some embodiments, the pad and trace layer may be deposited on another layer of the display stack (e.g., color filter substrate 225), in which case pressure sensing layer 314 and biasing layer 316 may also be rearranged accordingly.

Referring now to FIG. 4, there is illustrated a plan view of one example pad layout for the display assembly 300 of FIG. 3.

A plurality of pads 320 are arranged in a grid fashion. Although only nine pads are shown, it will be understood that a larger number of pads may be used. The number of individual pads can be selected to provide high resolution spatial detection, for example at the sub-millimeter level.

Each pad 320 has a corresponding conductive trace 325, which is operatively connected to flexible printed circuit 380, which connects to an external driver provided, for example on display subassembly 100. This allows the pads and traces to be implemented with existing cover lens or color filter manufacturing workflows.

The traces 325 may be formed of an optically transparent conductor such as ITO or IZO. Traces 325 may be routed in a regularized or repeating pattern, to facilitate placement of the pads 320 in a desired array pattern. In some cases, traces at the periphery of the display may be formed of an optically opaque conductor that exhibits lower resistance. As the traces do not switch at high frequency and need not switch simultaneously in pro-cap sensing, and further because the traces ― being thin relative to the pads - occupy considerably less area than the pads, the effect of noise from the conductive traces is negligible.

The use of discrete pads 320 with a biasing layer 316 enables two forms of projected capacitive touch detection: mutual capacitance with two ITO layers; and self-capacitance with only the top patterned ITO layer.

In contrast to conventional pro-cap devices, which drive transmitter and receiver traces sequentially, monitoring of each of the pads 320 can be simultaneous, meaning there is no requirement for separate transmit and receive acts. Preferably, touch event detection can be synchronized with display programming to minimize or avoid signal interference from switching display pixels. Moreover, pads can be sensed multiple times within a display frame period to improve detection signal-to-noise ratio. This is contrary to conventional touch panel displays, where touch event detection is typically not synchronized to display functions.

In some embodiments, pressure sensing may be triggered in response to a capacitive touch detection, allowing for similar power consumption as with conventional capacitive touch sensing devices.

In some alternate embodiments, TFT amplification circuits may be printed or provided within each pad 320, allowing for in situ amplification rather than amplification in display subassembly 100. This approach may involve TFT processing of the cover lens or color filter, for example, but can significantly improve signal-to-noise ratio, as the detected signal charge can be amplified without any signal deterioration resulting from RC propagation along conductive traces 325.

TFTs may be more opaque than ITO traces or pads, and thus may be aligned to the display's black matrix (BM) to minimize the impact on light transmittance. The BM is typically located on the color filter glass and may be marked with alignment marks, which can be used to align TFT amplification circuits to minimize visual artifacts.

In still further alternate embodiments, TFT amplification circuits may be printed or provided along a periphery of the cover lens or color filter, which typically is obscured by an opaque bezel, thus reducing or eliminating the requirement for alignment with the display BM. Short conductive traces may be provided between each pad 320 and the amplification circuits. This approach represents a reduction in signal-to-noise ratio (SNR) relative to in situ amplification, while still providing a modest gain in SNR relative to off-layer amplification.

Although TFT has been used as an example of a technology suitable for on-glass amplification circuits, other technologies such as amorphous silicon (a-Si), low temperature polysilicon (LTPS), metal oxide TFT (IGZO, MOx), organic TFTs, and the like may also be used.

In some embodiments, pads 320 and conductive traces 325 can be leveraged to perform both conventional pro-cap sensing of touch events and pressure sensing.

Referring now to FIG. 5, there is illustrated a simplified schematic diagram of an example approach for combined pro-cap and pressure sensing.

A pad 550, such as a pad 320, may be connected (e.g., via a conductive trace 325 and a flexible printed circuit 580), to a pressure sensing circuit 510 and a capacitive sensing circuit 530. Although only one pad and one of each type of sensing circuit is illustrated in FIG. 5, in practice, each individual pad 320 will have a corresponding pressure sensing circuit 510 and a corresponding capacitive sensing circuit 530, allowing all pads to be monitored simultaneously.

A control circuit 540 may selectively enable and disable switches 521 and 522, such that only one of pressure sensing circuit 510 and capacitive sensing circuit 530 is operatively coupled to pad 550 at any one time. In some embodiments, a single control circuit 540 may regulate a plurality of switches for a plurality of pads 550.

Control circuit 540 may synchronize the readout and sensing of touch events to the display frame blanking period, for example, to further enhance SNR.

Capacitive sensing circuit 530 is generally a conventional pro-cap detection and amplification circuit.

Referring now to FIG. 6, there is illustrated a schematic diagram of an example pressure sensing circuit 600, such as may be used for pressure sensing circuit 510.

Pressure sensing circuit 600 is operatively coupled to a pad 605, and has a reset transistor 612, an integrating transistor 615 and an addressing transistor 610. Each transistor 612, 615 and 610 may be a PMOS or NMOS transistor, for example, depending on the specific circuit configuration.

In operation, an output of pad 605 is connected to a gate of transistor 615, which serves as an integrator. In the example shown, a source of transistor 615 is connected to a bulk supply voltage, causing a drain terminal of transistor 615 to integrate the input to the gate of transistor 615. This integrated output can be coupled to a detection line 660 when an addressing transistor 610 is switched on.

The integrated output can be provided to a column amplifier 630, correlated double sampler 635, and digitized using an analog to digital convertor (ADC) 650.

Correlated double sampler 635 may be used to improve signal accuracy and signal-to-noise ratio. Generally, correlated double sampling is a technique used when measuring sensor outputs, which allows an undesired offset to be removed from a measured value (e.g., voltage, current). To perform correlated double sampling, the output of a sensor may be measured twice: once in a known condition and again in an unknown condition. The value measured during the known condition can be subtracted from the value measured during the unknown condition.

Correlated double sampling is used, for example, in switched capacitor opamps to improve the gain of a charge-sharing amplifier, while adding an extra phase.

In the described embodiments, correlated double sampling may be performed by measuring the output of a pad after a reset is performed (e.g., the known condition) and subtracting this output from the output at the end of an integration period (e.g., the unknown condition). The reset may be performed, for example, by triggering reset transistor 612.

In some embodiments, the correlated double sampler 635 may be omitted.

Pressure sensing circuit 600 does not require that a pad provide an output voltage concurrently with the detection and amplification. Accordingly, a user's touch may occur separately from the detection event.

Reset transistor 612 can be activated to reset the output pad 605 to a default voltage (e.g., Vreset). This reset pulse may also act to erase any material memory effect that may exist in the pressure sensing element, which could affect the measurement calibration.

In some embodiments, an alternate geometry for the pads and traces may be used.

Referring now to FIG. 7, there is illustrated an example cover assembly with example pad and trace geometry, which may be used for both pro-cap and pressure sensing as described herein.

Assembly 700 is generally analogous to cover assembly 150, however each vertical trace 760 may have one or more integrated sensing pads 761, and is connected to a flexible printed circuit 780 via connectors 775.

Similarly, each horizontal trace 755 may have one or more integrated driving pads 756, and is connected to flexible printed circuit 780 via connectors 770.

The use of enlarged, integrated pads both for driving and sensing can improve touch sensitivity with little or no change in the capacitance induced by an intermediate pressure sensing layer.

In general, it is desirable to increase the change in capacitance between the driving and sensing electrodes (or layers) that occurs in response to a touch. This change in capacitance can be increased by maximizing fringing fields. Electrode shapes can be selected to maximize fringing fields. In some cases, electrode shapes may result in a lower absolute capacitance, but a larger change in capacitance relative to some baseline shape.

Accordingly, the shapes each integrated sensing pad and each integrated driving pad may be selected to increase and maximize the fringe capacitance (fringing field) between the driving and sensing electrodes (or between the sensing electrode and biasing layer).

Referring now to FIG. 8, there is illustrated another cover assembly with example pad and trace geometry. The modified pad geometries may serve to increase the number of fringing fields, improving capacitive touch detection.

Cover assembly 800 is generally analogous to cover assembly 700. A plurality of horizontal traces 855 each have one or more integrated driving pads 859, and are connected to a flexible printed circuit 880 via connectors 870. A plurality of vertical traces 860 each have one or more integrated sensing pads 864, and are connected to flexible printed circuit 880 via connectors 875. Each driving pad 859 may have a diameter of approximately 5 mm, for example, and each sensing pad sized accordingly.

As shown in FIG. 8, each integrated sensing pad 864 has a rounded shape, as illustrated. Likewise, each integrated driving pad 859 also has a rounded shape. However, various other shapes and configurations for the padsmay also be used. For example, the driving and sensing pads may have polygonal shapes with a number of sides between 3 and 8, for example. In general, those shapes that maximize fringe capacitance between the sensing and driving electrodes may be preferred.

Although the described embodiments have been described primarily with reference to "one-glass solution" display technologies, the described techniques are applicable to many other display assembly structures, including "in-cell", "on-cell", and laminated panel approaches. In general, the described embodiments provide analog pressure sensing combined with conventional digital touch methods, such as projected capacitive sensing. The described embodiments also allow for high signal to noise ratio, enabling accurate, fast and sensitive touch and force sensing, as well as ultra-low power modes that significantly improve battery life and device operation times compared to known touch panel architectures and technologies.

Referring now to FIG. 9, there is illustrated a simplified schematic of an example touch event signal flow 900.

Signal flow 900 occurs between touch sensitive elements of a touch sensor 910, such as pro-cap or pressure sensing elements, a touch sensing integrated circuit 940, a display driver 930 and a display 920.

Touch sensing integrated circuit 940 includes an amplifier 942, as described herein, and a signal processor 944, which performs cleanup and touch detection of the raw amplified signal. For example, signal processor 944 may resolve multiple closely spaced touches as a single touch event, or may determine that a sequence of touch events relates to a "swipe" action.

The processed touch signal may be provided to a processor such as display driver 930, and in particular to a display frame buffer 934. Frame buffer 934 may prerender and store display data before it is actually displayed by display 920. Pre-rendered data may include "off-screen" data, such as data that is not intended for display in a current view, but which may "scroll" into view in response to a user input, such as a swipe input.

To improve responsiveness to touch events, and to reduce processing latency, raw touch event data may be provided to a touch overlay buffer 932 of the display driver 930 processor. Touch overlay buffer 932 may treat the data from the touch electrode array as a pixelated array of sensors. In effect, touch data may be interpreted as an initial image map, and compressive sensing used to identify the different touch events, including pro-cap and pressure-sensing multi-touch. Pressure levels may be interpreted as levels of grey in the initial image map. This signal processing technique enables fast acquisition and reconstruction of the touch event.

Accordingly, to reduce latency, the raw touch signal from sensor elements 910 is sent directly into the display frame buffer 934 via the touch overlay buffer 932. At the same time, the raw touch signal is provided to the touch sensing integrated circuit 940, where it is amplified by amplifier 942, and processed and analyzed for location and force parameters by signal processor 944.

Signal processor 944 may also perform correlated double sampling, for example, to interpret pressure data, carry out signal clean-up, and to generate a processed image map for the multi-touch event. The processed image map may also contain levels of grey representing pressure levels, such that each pixel in the image map has a respective pressure level mapped as a level of grey.

The processed data, including the processed image map, may be provided to the frame buffer, where it can be used to refine the raw touch signal or initial image map through combining or integration. Subsequently, frame buffer 934 determines which information should be rendered and pushed to display 920.

By using the raw, unprocessed touch event data, frame buffer 934 can begin pre-rendering display content that is expected to be needed for a display frame based on the touch event (e.g., swipe a certain amount). Once the fully processed touch event data is received, the pre-rendered data can be confirmed and pushed to display 920, or may be adjusted with incremental cost to render some additional data.

Although described herein as being performed by signal processor 944, some or all of the described signal procession actions could also be performed by other elements, including a host processor (not shown), or within display driver 930.

It will be appreciated that numerous specific details are set forth in order to provide a thorough understanding of the exemplary embodiments described herein. However, it will be understood by those of ordinary skill in the art that the embodiments described herein may be practiced without these specific details. In other instances, well-known methods, procedures and components have not been described in detail so as not to obscure the embodiments described herein.

## Claims

1. A projected capacitance touchscreen device comprising a pressure sensing assembly (300), the pressure sensing assembly comprising:
a biasing electrode layer (316);
a sensing electrode layer (312) comprising a plurality of conductive traces (325),
wherein each trace comprises one or more sensing pads (320, 550);
a piezoelectric layer (314) provided between the biasing electrode layer and the sensing electrode layer, wherein the piezoelectric layer acts as a dielectric;
a detection circuit (500) operatively connected to the plurality of conductive traces of the sensing electrode layer and comprising a pressure sensing circuit (510) and a capacitive sensing circuit (530), wherein the detection circuit is switchable between a first mode and a second mode such that only one of the pressure sensing circuit and the capacitive sensing circuit is operatively coupled to a conductive trace of the plurality of conductive traces at any one time, wherein:
in the first mode the capacitive sensing circuit is configured to detect a change in capacitance at the conductive trace, and
in the second mode the pressure sensing circuit is configured to detect a voltage induced across the piezoelectric layer, between the biasing electrode layer and the conductive trace;
wherein the detection circuit is configured to determine the location of an applied force based on the detected changes in capacitance and the magnitude of an applied force based on the detected changes in induced voltages.

2. The device of claim 1, wherein the one or more sensing pads (320, 550) are shaped to maximize fringing fields and a change in capacitance between the sensing electrode layer (312) and the biasing electrode layer (316) in response to stimulus.

3. The device of any preceding claim, wherein the one or more sensing pads (320, 550) have a polygonal shape.

4. The device of claim 1, wherein each conductive trace (325) of the sensing electrode layer (312) terminates in a respective one of the one or more sensing pads (320, 550).

5. The device of any one of claims 1 to 4, further comprising a processor, wherein the processor is configured to interpret pressure data from the one or more sensing pads (320, 550) as an image map.

6. The device of claim 5, wherein the pressure data comprises a plurality of pressure levels, and wherein each pixel in the image map has a respective pressure level mapped as a level of grey.

7. The device of claim 5 or claim 6, wherein the pressure data is interpreted using correlated double sampling (635).

8. The device of any one of claims 5 to 7, wherein the pressure data is interpreted using compressive sensing.

## Patentansprüche

1. Projiziert-kapazitive Berührungsbildschirmvorrichtung, umfassend eine Druckmessbaugruppe (300), wobei die Druckmessbaugruppe umfasst:
eine Vorspannungselektrodenschicht (316);
eine Messelektrodenschicht (312), die mehrere Leiterbahnen (325) umfasst, wobei jede Bahn eine oder mehrere Messflächen (320, 550) umfasst;
eine piezoelektrische Schicht (314), die zwischen der Vorspannungselektrodenschicht und der Messelektrodenschicht vorgesehen ist, wobei die piezoelektrische Schicht als Dielektrikum fungiert;
eine Erkennungsschaltung (500), die mit den mehreren Leiterbahnen der Messelektrodenschicht wirkverbunden ist und eine Druckmessschaltung (510) und eine kapazitive Messschaltung (530) umfasst, wobei die Erkennungsschaltung zwischen einem ersten Modus und einem zweiten Modus umschaltbar ist, sodass jeweils nur eine von der Druckmessschaltung und der kapazitiven Messschaltung mit einer Leiterbahn der mehreren Leiterbahnen wirkgekoppelt ist, wobei:
in dem ersten Modus die kapazitive Messschaltung dazu konfiguriert ist, eine Kapazitätsänderung an der Leiterbahn zu erkennen, und
in dem zweiten Modus die Druckmessschaltung dazu konfiguriert ist, eine an der piezoelektrischen Schicht zwischen der Vorspannungselektrodenschicht und der Leiterbahn induzierte Spannung zu erkennen;
wobei die Erkennungsschaltung dazu konfiguriert ist, die Stelle einer ausgeübten Kraft auf Grundlage der erkannten Kapazitätsänderungen und die Größe einer ausgeübten Kraft auf Grundlage der erkannten Änderungen der induzierten Spannungen zu bestimmen.

2. Vorrichtung nach Anspruch 1, wobei die eine oder mehreren Messflächen (320, 550) derart geformt sind, dass Streufelder und eine Kapazitätsänderung zwischen der Messelektrodenschicht (312) und der Vorspannungselektrodenschicht (316) als Reaktion auf einen Reiz maximiert werden.

3. Vorrichtung nach einem vorhergehenden Anspruch, wobei die eine oder mehreren Messflächen (320, 550) eine vieleckige Form aufweisen.

4. Vorrichtung nach Anspruch 1, wobei jede Leiterbahn (325) der Messelektrodenschicht (312) in einer jeweiligen der einen oder mehreren Messflächen (320, 550) endet.

5. Vorrichtung nach einem der Ansprüche 1 bis 4, ferner umfassend einen Prozessor, wobei der Prozessor dazu konfiguriert ist, Druckdaten von der einen oder den mehreren Messflächen (320, 550) als eine Bildkarte zu interpretieren.

6. Vorrichtung nach Anspruch 5, wobei die Druckdaten mehrere Druckwerte umfassen und wobei jedes Pixel in der Bildkarte einen jeweiligen Druckwert aufweist, der als ein Grauwert kartiert ist.

7. Vorrichtung nach Anspruch 5 oder Anspruch 6, wobei die Druckdaten unter Verwendung einer korrelierten Doppelabtastung (635) interpretiert werden.

8. Vorrichtung nach einem der Ansprüche 5 bis 7, wobei die Druckdaten unter Verwendung einer Kompressionsmessung interpretiert werden.

## Revendications

1. Dispositif à écran tactile à capacité projetée comprenant un ensemble de détection de pression (300), l'ensemble de détection de pression comprenant :
une couche d'électrode de polarisation (316) ;
une couche d'électrode de détection (312) comprenant une pluralité de traces conductrices (325), chaque trace comprenant un ou plusieurs plots de détection (320, 550) ;
une couche piézoélectrique (314) disposée entre la couche d'électrode de polarisation et la couche d'électrode de détection, ladite couche piézoélectrique agissant en tant que diélectrique ;
un circuit de détection (500) raccordé fonctionnellement à la pluralité de traces conductrices de la couche d'électrode de détection et comprenant un circuit de détection de pression (510) et un circuit de détection capacitif (530), ledit circuit de détection pouvant être commuté entre un premier mode et un second mode de sorte qu'un seul du circuit de détection de pression et du circuit de détection capacitif soit couplé de manière fonctionnelle à une trace conductrice de la pluralité de traces conductrices à un moment donné,
dans le premier mode, ledit circuit de détection capacitif étant conçu pour détecter un changement de capacité au niveau de la trace conductrice, et
dans le second mode, ledit circuit de détection de pression étant conçu pour détecter une tension induite à travers la couche piézoélectrique, entre la couche d'électrode de polarisation et la trace conductrice ;
ledit circuit de détection étant conçu pour déterminer l'emplacement d'une force appliquée sur la base des changements détectés de capacité et l'amplitude d'une force appliquée sur la base des changements détectés de tensions induites.

2. Dispositif selon la revendication 1, ledit ou lesdits plots de détection (320, 550) étant façonnés pour maximiser les champs de frange et un changement de capacité entre la couche d'électrode de détection (312) et la couche d'électrode de polarisation (316) en réponse à un stimulus.

3. Dispositif selon une quelconque revendication précédente, ledit ou lesdits plots de détection (320, 550) possédant une forme polygonale.

4. Dispositif selon la revendication 1, chaque trace conductrice (325) de la couche d'électrode de détection (312) se terminant par l'un respectif du ou des plots de détection (320, 550).

5. Dispositif selon l'une quelconque des revendications 1 à 4, comprenant en outre un processeur, ledit processeur étant configuré pour interpréter les données de pression en provenance du ou des plots de détection (320, 550) en tant que carte d'image.

6. Dispositif selon la revendication 5, lesdites données de pression comprenant une pluralité de niveaux de pression, et chaque pixel dans la carte d'image possédant un niveau de pression respectif cartographié sous forme de niveau de gris.

7. Dispositif selon la revendication 5 ou la revendication 6, lesdits données de pression étant interprétées à l'aide d'un double échantillonnage corrélé (635).

8. Dispositif selon l'une quelconque des revendications 5 à 7, lesdites données de pression étant interprétées à l'aide d'une détection de compression.
